# EUROPEAN PATENT APPLICATION

(11) **EP 2 945 284 A1**
(43) Date of publication of application: **18.11.2015**
(21) Application number: 15157718.6
(22) Date of filing: 05.03.2015
(51) Int. Cl.: H03F 1/02, H03F 3/21, H03F 3/72

(54) **Method and apparatus for performing signal amplifying with aid of switching control**

(30) Priority: 13.05.2014 US 201414275897
(71) Applicant: MediaTek, Inc, Hsin-Chu 300 (TW)
(72) Inventor: Wang, Tze-Chien, 302 Hsinchu County (TW)
(74) Representative: Hoefer & Partner Patentanwälte mbB

(57) **Abstract**

A method and an apparatus (100) for performing signal amplifying with aid of switching control are provided, where the method may include the steps of: modulating an input signal of a gain stage (110) based on one of several modulation schemes to generate at least one first amplified result of a first amplifying path (110-1) of the gain stage (110); modulating the input signal of the gain stage (110) based on one of the several modulation schemes to generate at least one second amplified result of a first amplifying path (110-2) of the gain stage (110); and generating an amplified signal of the gain stage (110) based on at least the first amplified result and the second amplified result. In addition, at least one switching time point of the first amplifying path (110-1) for switching between the several modulation schemes and one switching time point of the first amplifying path (110-2) for switching between the several modulation schemes are non-overlapped.

## Description

The present invention relates to methods and apparatus for performing signal amplifying with aid of switching control according to the pre-characterizing clauses of claims 1, 9, and 12.

A conventional amplifying circuit such as a single-ended audio band amplifier may suffer from the problem of the limited operational speed, where the operational speed may be limited due to a pole of a current mirror therein, and, typically, flicker noise may greatly degrade the signal quality when the operational speed reaches the order of 100 MHz or 1 MHz. According to the related art, different circuit designs are proposed to enhance the performance of the conventional amplifying circuit. However, further problems such as some side effects may be introduced. For example, in order to reduce the flicker noise, the input stage area of the chip may be significantly increased. In another example, in order to reduce a certain type of noise, additional filtering circuits (e.g. a notch filter disclosed in U.S. Patent No. 7,292,095) are utilized, causing the circuitry to be more complicated. Thus, how to reduce noise and offset in an amplifying circuit has become an important issue to be solved.

This in mind, the present invention aims at providing a method for performing signal amplifying with aid of switching control and an associated apparatus that reduce noise and offset in an amplifying circuit.

This is achieved by methods and related apparatus according to claims 1, 9, and 12. The dependent claims pertain to corresponding further developments and improvements.

In one aspect, the disclosure features a method for performing signal amplifying with aid of switching control, where the method comprises the steps of: modulating an input signal of a gain stage based on one of several modulation schemes to generate at least one first amplified result of a first amplifying path of the gain stage; modulating the input signal of the gain stage based on one of the several modulation schemes to generate at least one second amplified result of a second amplifying path of the gain stage; and generating an amplified signal of the gain stage based on at least the first amplified result and the second amplified result. In addition, at least one switching time point of the first amplifying path for switching between the several modulation schemes and one switching time point of the second amplifying path for switching between the several modulation schemes are non-overlapped.

In one aspect, the method may further comprise: selectively inputting the input signal of the gain stage and a first inverted signal of the input signal of the gain stage into the first amplifying path of the gain stage to generate at least one first amplified result of the first amplifying path; selectively inputting the input signal of the gain stage and a second inverted signal of the input signal of the gain stage into the second amplifying path of the gain stage to generate at least one second amplified result of the second amplifying path; and combining amplified results of different amplifying paths of the gain stage to generate an amplified signal of the gain stage, wherein the amplified results of the amplifying paths of the gain stage comprise the at least one first amplified result of the first amplifying path and the at least one second amplified result of the second amplifying path; wherein switching time points of the first amplifying path and switching time points of the second amplifying path are different from each other.

In one aspect, the disclosure features a method for performing signal amplifying with aid of switching control, where the method comprises the steps of: selectively enabling or disabling N amplifying paths of a gain stage based on N switching control signals, respectively, where N is a positive integer equal to or larger than two; and generating an amplified signal of the gain stage based on N amplified results generated by the N amplifying paths. In addition, the N amplifying paths are not disabled at the same time. For example, the step of selectively enabling or disabling N amplifying paths comprises selectively inputting or not inputting an input signal to the N amplifying paths. In another example, the step of selectively enabling or disabling N amplifying paths comprises selectively outputting or not outputting amplified results of the N amplifying paths.

In one aspect, the disclosure features an apparatus for performing signal amplifying with aid of switching control, where the apparatus comprises a switching control circuit, and further comprises a gain stage which is coupled to the switching control circuit. The switching control circuit is arranged to perform switching control, and the gain stage is arranged to operate under control of the switching control circuit. More particularly, the gain stage modulates an input signal of the gain stage based on one of several modulation schemes to generate at least one first amplified result of a first amplifying path of the gain stage, modulates the input signal of the gain stage based on one of the several modulation schemes to generate at least one second amplified result of a second amplifying path of the gain stage, and generates an amplified signal of the gain stage based on at least the first amplified result and the second amplified result. In addition, at least one switching time point of the first amplifying path for switching between the several modulation schemes and one switching time point of the second amplifying path for switching between the several modulation schemes are non-overlapped.

In one aspect, the gain stage selectively inputs the input signal of the gain stage and a first inverted signal of the input signal of the gain stage into the first amplifying path of the gain stage to generate at least one first amplified result of the first amplifying path, selectively inputs the input signal of the gain stage and a second inverted signal of the input signal of the gain stage into the second amplifying path of the gain stage to generate at least one second amplified result of the second amplifying path, and combines amplified results of different amplifying paths of the gain stage to generate an amplified signal of the gain stage, wherein the amplified results of the amplifying paths of the gain stage comprise the at least one first amplified result of the first amplifying path and the at least one second amplified result of the second amplifying path. In addition, any of switching time points of the first amplifying path and any of switching time points of the second amplifying path are different from each other.

It is an advantage of the present invention that the aforementioned method and the associated apparatus can automatically decrease or cancel the offset and noise without introducing some side effects such as that mentioned above. As compared to the conventional methods, the operating speed of the present invention is not sacrificed and the chip area can be reduced, where it is unnecessary to implement additional filtering circuits that are used as a remedy for noise (e.g. the ripple noise or the chopping noise). In addition, when implementing according to the present invention method and the associated apparatus, the goal of low noise and low offset in comparison with that in the conventional amplifying circuit can be achieved with ease.

In the following, the invention is further illustrated by way of example, taking reference to the accompanying drawings. Thereof
FIG. 1 is a diagram of an apparatus for performing signal amplifying with aid of switching control according to a first embodiment of the present invention,
FIG. 2 illustrates some amplifying paths of one of the gain stages shown in FIG. 1 according to an embodiment of the present invention,
FIG. 3 illustrates a flowchart of a method for performing signal amplifying with aid of switching control according to an embodiment of the present invention,
FIG. 4 illustrates the waveforms of some switching control signals involved with the method shown in FIG. 3 according to an embodiment of the present invention,
FIG. 5 illustrates some amplifying paths of one of the gain stages shown in FIG. 1 according to another embodiment of the present invention,
FIG. 6 illustrates the waveforms of some switching control signals involved with the method shown in FIG. 3 according to another embodiment of the present invention, and
FIG. 7 illustrates the waveforms of some switching control signals involved with the method shown in FIG. 3 according to an embodiment of the present invention.

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

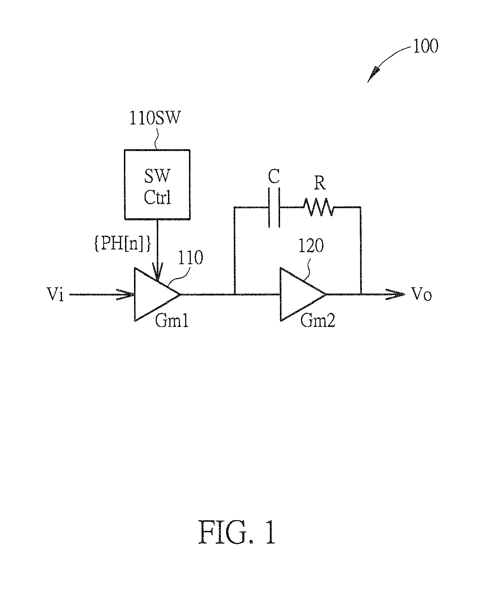

Please refer to FIG. 1, which illustrates a diagram of an apparatus 100 for performing signal amplifying with aid of switching control according to a first embodiment of the present invention, where the apparatus 100 may comprise at least one portion (e.g. a portion or all) of an amplifying device. As shown in FIG. 1, the apparatus 100 may comprise two gain stages 110 and 120 (respectively labeled "Gm1" and "Gm2", which stand for their equivalent transconductance values, respectively), a switching control circuit 110SW (labeled "SW Ctrl", for brevity), and some impedance components such as a capacitor C and a resistor R for performing Miller compensation, where the architecture shown in FIG. 1 can be regarded as a two stage operational amplifier (OP Amp). The notation Vi (whose suffix "i" stands for input) may represent the input signal of the gain stage 110 (e.g., an input voltage signal), and the notation Vo (whose suffix "o" stands for output) may represent the output signal of the gain stage 120 (e.g., an output voltage signal). In addition, the gain stage 110 may comprise a plurality of amplifying paths {110-n} such as N amplifying paths 110-1, 110-2, ..., and 110-N (not shown in FIG. 1), where the notation N represents a positive integer that is equal to or greater than two, and the notation n represents an index falling within the range of the interval [1, N], such as a positive integer that is less than or equal to N. The overall transconductance values of N amplifying paths constitute Gm1. Additionally, the switching control circuit 110SW may generate and output a plurality of switching control signals {PH[n]} such as N switching control signals PH[1], PH[2], ..., and PH[N], for performing switching control on the gain stage 110.

According to this embodiment, the switching control circuit 110SW is arranged to perform switching control, and the gain stage 110 is arranged to operate under control of the switching control circuit 110SW. More particularly, the input signal Vi is first modulated based on several modulation schemes before being entered into the amplifying paths and the outputs of the amplifying paths are demodulated based on several demodulation schemes before being combined together to serve as an output (an amplified signal) of the gain stage 110. The switching control signals {PH[n]} controls the selection of the several modulation/demodulation schemes (that is, controls the switching between the several modulation/demodulation schemes). In this embodiment, switching time points of each amplifying path are non-overlapped (or time-interlaced). However, this is not meant to be a limitation of the present invention. For example, it is also practicable as long as the switching time points of at least two amplifying path are different/non-overlapped.

According to some embodiments of the present invention, the aforementioned modulation schemes comprise multiplying the input signal Vi with a positive value, a zero value or a negative value (i.e., providing a non-inverted version, a zero-version or an inverted version of the input signal Vi to the corresponding amplifying path), and the aforementioned demodulation schemes comprise multiplying the amplified results of the amplifying paths with a positive value, a zero value or a negative value (i.e., providing a non-inverted version, a zero-version or an inverted version of the amplified result of the corresponding amplifying path) to counteract the modulation effects.

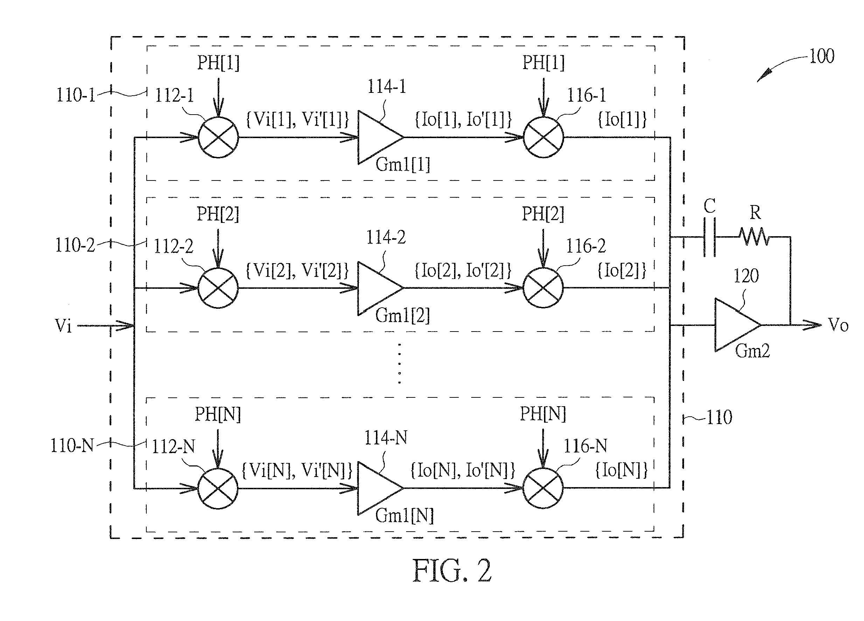

FIG. 2 illustrates some amplifying paths of one of the gain stages 110 and 120 shown in FIG. 1 according to an embodiment of the present invention, such as the N amplifying paths 110-1, 110-2, ..., and 110-N of the gain stage 110 mentioned above in a situation where the number N of the amplifying paths 110-1, 110-2, ..., and 110-N of the gain stage 110 can be equal to or greater than two.

As shown in FIG. 2, the N amplifying paths 110-1, 110-2, ..., and 110-N may comprise their own operational transconductance amplifiers 114-1, 114-2, ..., and 114-N (labeled "Gm1[1]", "Gm1[2]", ..., and "Gm1[N]", which respectively stand for their transconductance values), respectively, where each of these operational transconductance amplifiers 114-1, 114-2, ..., and 114-N is arranged to perform signal amplifying, and the summation of the transconductance values Gm1[1], Gm1[2], ..., and Gm1[N] is arranged to be equal to the equivalent transconductance value Gm1 of the gain stage 110 (i.e., Gm1[1] + Gml[2] + ... + Gml[N] = Gm1). In addition, the N amplifying paths 110-1, 110-2, ..., and 110-N may further comprise their own first switching units 112-1, 112-2, ..., and 112-N and second switching units 116-1, 116-2, ..., and 116-N, respectively, where each set of the sets of switching units {112-1, 116-1}, {112-2, 116-2}, ..., and {112-N, 116-N}, such as the set of switching units {112-n, 116-n} positioned on the amplifying path 110-n, can be arranged to perform switching according to the switching control signal PH[n], respectively.

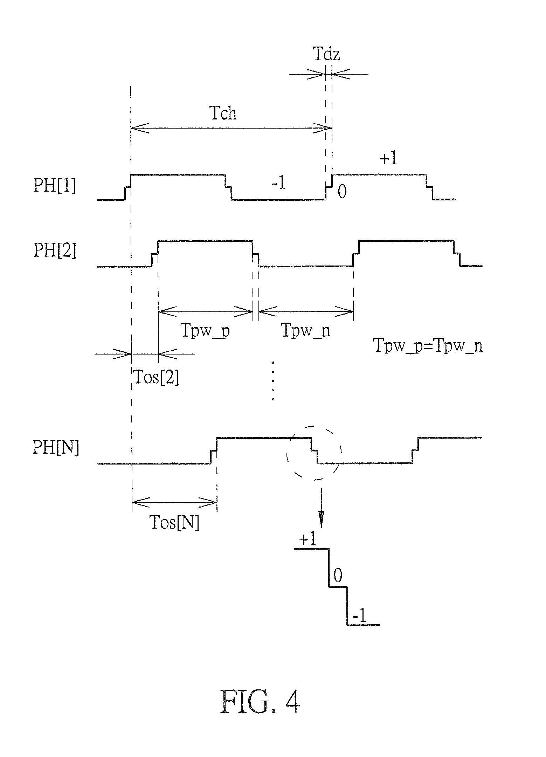

For example, when the switching control signal PH[n] is at a non-inverting state "+1" thereof (as shown in FIG. 4), the first switching unit 112-n of the amplifying path 110-n bypasses (e.g. multiply by a positive value such as "+1") the input signal Vi and inputs the input signal Vi into the operational transconductance amplifier 114-n of the amplifying path 110-n to generate an amplified result of the amplifying path 110-n, such as the amplified results {Io[n]} output from the operational transconductance amplifier 114-n. In addition, when the switching control signal PH[n] is at the non-inverting state "+1" thereof, the second switching unit 116-n of the amplifying path 110-n bypasses (e.g. multiply by "+1") this amplified result of the amplifying path 110-n. Thus, the amplified result Io[n] output from the operational transconductance amplifier 114-n is eventually output from the second switching unit 116-n of the amplifying path 110-n. Please note that the index n may vary from 1 to N.

In another example, when the switching control signal PH[n] is at an inverting state "-1" thereof (as shown in FIG. 4), the first switching unit 112-n of the amplifying path 110-n inverts (e.g. multiply by a negative value such as "-1") the input signal Vi to generate an inverted signal of the input signal Vi, such as the inverted portion Vi'[n] of the input signal Vi on the amplifying path 110-n, and inputs the inverted signal Vi'[n] of the input signal Vi into the operational transconductance amplifier 114-n of the amplifying path 110-n to generate an inverted amplified result of the amplifying path 110-n, such as the inverted amplified result Io'[n]. In addition, when the switching control signal PH[n] is at the inverting state "-1" thereof, the second switching unit 116-n of the amplifying path 110-n inverts (e.g. multiply by "-1") this inverted amplified result to generate another amplified result Io[n] of the amplifying path 110-n. Please note that the index n may vary from 1 to N.

Please note that, as the amplified results {Io[n]} output from the second switching unit 116-n of the amplifying path 110-n comprise the amplified results obtained from inverting (by using the second switching unit 116-n of the amplifying path 110-n) the inverted amplified results {Io'[n]} output from the operational transconductance amplifier 114-n, the amplified results {Io[n]} output from the second switching unit 116-n of the amplifying path 110-n can be regarded as a superset of the amplified results {Io[n]] output from the operational transconductance amplifier 114-n.

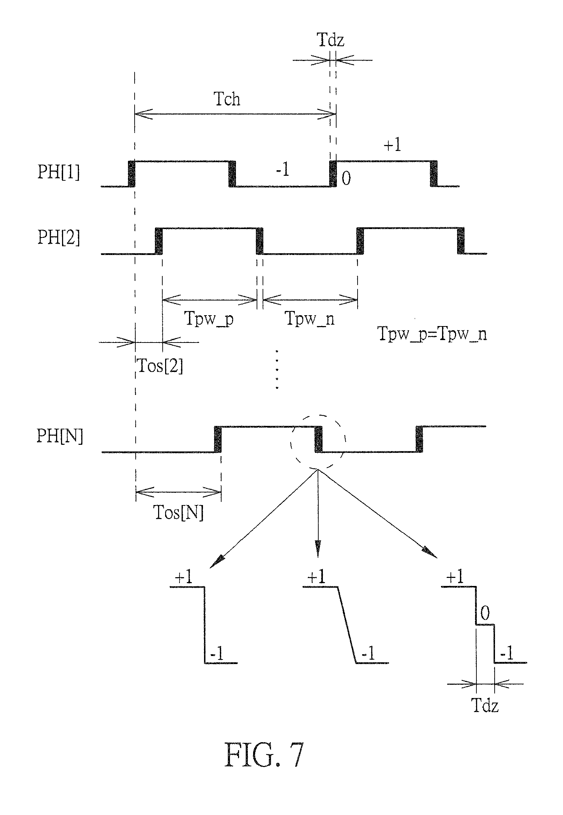

In addition, the switching control signal PH[n] may further have a zero state "0" thereof (as shown in FIG. 4), which causes the output of any of the first switching unit 112-n and the second switching unit 116-n on the amplifying path 110-n to be zero. Regarding function, the zero state "0" is not a must, where it is for ease of implementation since transition time between the non-inverting state "+1" and the inverting state "-1" cannot be zero in reality. For example, the transition from the non-inverting state "+1" to the zero state "0" can be done by simply disabling the +1 path (e.g. the path for the non-inverting state "+1"), which is safe in real circuit. More particularly, the transition from the non-inverting state "+1" to the inverting state "-1" may include disabling the +1 path (e.g. the path for the non-inverting state "+1") and enabling the -1 path (e.g. the path for the inverting state "-1"). Disastrous effect may happen if the aforementioned +1 path (e.g. the path for the non-inverting state "+1") and the aforementioned -1 path (e.g. the path for the inverting state "-1") are acting simultaneously during the transition. The insertion of the zero state "0" can make the transition safe. If the disastrous effect do not occur or can be tolerated, it could be omitted in some embodiments of the present invention. Please note that although three states ("+1", "0", "-1") of the switching control signal PH[n] are disclosed, this is for illustrative purposes only, and is not meant to be a limitation of the present invention; for example, the switching control signal PH[n] may have more than three states to switch between more than three modulation/demodulation schemes. A few possibilities are illustrated in FIG. 7, which will be explained later.

Additionally, at least one switching time points of one of the N amplifying paths 110-1, 110-2, ..., and 110-N and at least one switching time points of another one of the N amplifying paths 110-1, 110-2, ..., and 110-N are different or non-overlapped. In a preferred embodiment, any of the switching time points of one of the N amplifying paths 110-1, 110-2, ..., and 110-N and any of the switching time points of another one of the N amplifying paths 110-1, 110-2, ..., and 110-N are typically different from each other. More particularly, the switching control signals {PH[n]} do not switch their states at the same time. As a result, the amplifying apparatus 100 will not stop functioning during noise cancellation.

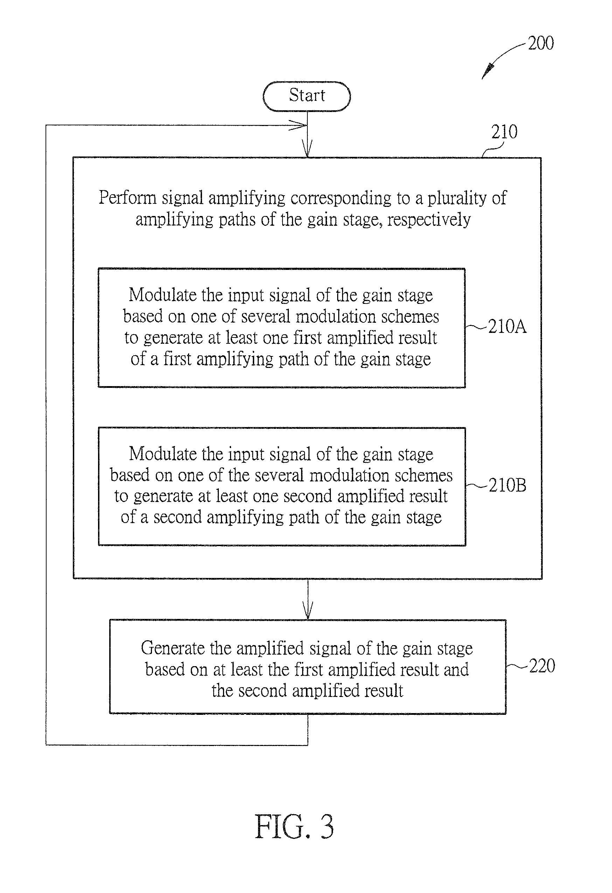

FIG. 3 illustrates a flowchart of a method 200 for performing signal amplifying with aid of switching control according to an embodiment of the present invention. The method 200 shown in FIG. 3 can be applied to the apparatus 100 shown in FIG. 1, and more particularly, can be applied to the architecture shown in FIG. 2. The method is described as follows.

In Step 210, the gain stage 110 performs signal amplifying corresponding to a plurality of amplifying paths of the gain stage 110, such as the aforementioned N amplifying paths 110-1, 110-2, ..., and 110-N, respectively. According to this embodiment, Step 210 may comprise multiple sub-steps such as Step 210A and Step 210B. This is for illustrative purposes only, and is not meant to be a limitation of the present invention. According to some variations of this embodiment, the number of sub-steps in Step 210 may be greater than or equal to two.

In Step 210A, a first amplifying path of the gain stage 110 modulates the input signal Vi of the gain stage 110 based on one of several modulation schemes. For example, the first amplifying path of the gain stage 110 can be the amplifying path 110-1 of the gain stage 110 shown in FIG. 2. The modulated input signal Vi[1]/Vi'[1] is then amplified and demodulated based on one of several demodulation schemes to generate at least one first amplified result of the first amplifying path of the gain stage 110.

In Step 210B, a second amplifying path of the gain stage 110 modulates the input signal Vi of the gain stage 110 based on one of the several modulation schemes. For example, the second amplifying path of the gain stage 110 can be the amplifying path 110-2 of the gain stage 110 shown in FIG. 2. The modulated input signal Vi[2]/Vi'[2] is then amplified and demodulated based on one of several demodulation schemes to generate at least one second amplified result of the second amplifying path of the gain stage 110.

In Step 220, the gain stage 110 generates the amplified signal of the gain stage 110 shown in FIG. 1 based on at least the first amplified result and the second amplified result. This is for illustrative purposes only, and is not meant to be a limitation of the present invention. According to some variations of this embodiment, in a situation where the number of sub-steps in Step 210 is greater than two, the gain stage 110 may generate the amplified signal of the gain stage 110 shown in FIG. 1 based on the first amplified result and the second amplified result and at least one other amplified result (such as the amplified result generated by the amplifying path 110-N of the gain stage 110.

Please note that at least one switching time point of the first amplifying path for switching between the several modulation schemes and one switching time point of the second amplifying path for switching between the several modulation schemes are non-overlapped. More particularly, the several modulation schemes may comprise providing a non-inverted version of the input signal, providing a zero-version of the input signal, and providing an inverted version of the input signal. For example, a time period of providing the zero-version of the input signal for the first amplifying path and a time period of providing the zero-version of the input signal for the second amplifying path are non-overlapped. In other words, the switching controller such as the switching control circuit 110SW shown in FIG. 1 selectively enables or disables the amplifying paths of the gain stage 110 based on the switching control signals by selectively inputting or not inputting the input signal Vi to the amplifying paths, but the amplifying paths are not disabled at the same time. Moreover, a time period of providing the non-inverted version of the input signal and a time period of providing an inverted version of the input signal are substantially even for better low noise cancellation performance.

Similarly, at least one switching time point of the first amplifying path for switching between the several demodulation schemes and one switching time point of the second amplifying path for switching between the several demodulation schemes are non-overlapped. More particularly, the several demodulation schemes may comprise providing a non-inverted version, a zero-version, and an inverted version of the amplified results. For example, a time period of providing the zero-version of the amplified result for the first amplifying path and a time period of providing the zero-version of the amplified result for the second amplifying path are non-overlapped. In other words, the switching controller such as the switching control circuit 110SW shown in FIG. 1 selectively enables or disables the amplifying paths of the gain stage 110 based on the switching control signals by selectively outputting or not outputting amplified results of the amplifying paths, but the amplifying paths are not disabled at the same time. Moreover, a time period of providing the non-inverted version of the amplified result and a time period of providing an inverted version of the amplified result are substantially even for better low noise cancellation performance.

As shown in FIG. 3, the operations of Step 210 and Step 220, together with the operations of the aforementioned sub-steps such as Step 210A and Step 210B, are illustrated, respectively. This is for illustrative purposes only, and is not meant to be a limitation of the present invention. Please note that at least one portion (e.g. a portion or all) of the operations in Step 210A and at least one portion (e.g. a portion or all) of the operations in Step 210B can be performed at the same time. In addition, at least one portion (e.g. a portion or all) of the operations in Step 210 and at least one portion (e.g. a portion or all) of the operations in Step 220 can be performed at the same time.

In addition, Step 210A may be controlled by a first switching control signal (such as the switching control signal PH[1]), and Step 210B may be controlled by a second switching control signal (such as the switching control signal PH[2]), where the second switching control signal is a delayed version of the first switching control signal.

FIG. 4 illustrates the waveforms of some switching control signals PH[1], PH[2], ..., and PH[N] involved with the method 200 shown in FIG. 3 according to an embodiment of the present invention, where the number N of the amplifying paths 110-1, 110-2, ..., and 110-N of the gain stage 110 can be equal to or greater than two in this embodiment.

As shown in FIG. 4, each of the switching control signals PH[1], PH[2], ..., and PH[N] of this embodiment is a periodic signal, and the switching control signals PH[1], PH[2], ..., and PH[N] of this embodiment are substantially the same except that they correspond to different phases, respectively. For example, the switching control circuit 110SW may generate the switching control signal PH[2] by delaying the switching control signal PH[1] with a delay amount Tos[2], and the switching control circuit 110SW may generate the switching control signal PH[3] by delaying the switching control signal PH[1] with a delay amount Tos[3], and the rest may be deduced by analogy.

According to this embodiment, each of the delay amounts Tos[2], Tos[3], ..., and Tos[N] is less than ((Tch - 2Tdz) / 2), where the notation Tdz may represent the length of a dead zone corresponding to the zero state "0" mentioned above in a period of any of the switching control signals PH[1], PH[2], ..., and PH[N] of this embodiment, and the notation Tch may represent the length of a whole period. In addition, the pulse width Tpw_p of the positive pulse in the period and the pulse width Tpw_n of the negative pulse in the period can be equal to each other, where the positive pulse corresponds to the non-inverting state "+1" mentioned above, and the negative pulse corresponds to the inverting state "-1" mentioned above. For example, Tpw_p = Tpw_n = ((Tch - 2Tdz) / 2). As a result of controlling the pulse width Tpw_p of the positive pulse in the period and the pulse width Tpw_n of the negative pulse in the period to be equal to each other, each amplifying path of the N amplifying paths 110-1, 110-2, ..., and 110-N can be evenly switched. As each amplifying path of the N amplifying paths 110-1, 110-2, ..., and 110-N can be evenly switched in this embodiment, noise/mismatch cancellation can be achieved with ease.

In practice, the delay amounts Tos[2], Tos[3], ..., and Tos[N] can be different. More particularly, any two of the delay amounts Tos[2], Tos[3], ..., and Tos[N] are different from each other. For example, Tos[2] < Tos[3] < ... < Tos[N]. In another example, (Tos[3] - Tos[2]) = (Tos[4] - Tos[3]) = ... = (Tos[N] - Tos[N - 1]). In another example, (Tos[3] - Tos[2]) = (Tos[4] - Tos[3]) = ... = (Tos[N] - Tos[N - 1]) = Tos[2]. As the switching instants (or more particularly, the dead zone durations) do not coincide, when one of the N amplifying paths 110-1, 110-2, ..., and 110-N is switching, the others of the N amplifying paths 110-1, 110-2, ..., and 110-N (or the other of the N amplifying paths 110-1, 110-2, ..., and 110-N, in a situation where N = 2) are still functioning. Thus, there will be no dead-time for the amplification function of the apparatus 100.

As mentioned, each of the switching control signals PH[1], PH[2], ..., and PH[N] of this embodiment is a periodic signal, and the switching control signals PH[1], PH[2], ..., and PH[N] of this embodiment are substantially the same except that they correspond to different phases, respectively. This is for illustrative purposes only, and is not meant to be a limitation of the present invention. According to some variations of this embodiment, the waveforms of some switching control signals PH[1], PH[2], ..., and PH[N] may vary. As long as the switching instants do not coincide, when one of the N amplifying paths 110-1, 110-2, ..., and 110-N is switching, at least one of the other N amplifying paths 110-1, 110-2, ..., and 110-N are still functioning. Thus, there will be no dead-time for the amplification function of the apparatus 100. In addition, as long as each amplifying path of the N amplifying paths 110-1, 110-2, ..., and 110-N can be evenly switched in these variations (e.g. the summation of the pulse widths of the positive pulses of the switching control signal PH[n] in a specific time interval and the summation of the pulse widths of the negative pulses of the switching control signal PH[n] in the specific time interval are the same or approximately the same, or the difference between the summation of the pulse widths of these positive pulses in the specific time interval and the summation of the pulse widths of these negative pulses in the specific time interval is within a predetermined value), the noise/mismatch cancellation can be achieved with ease.

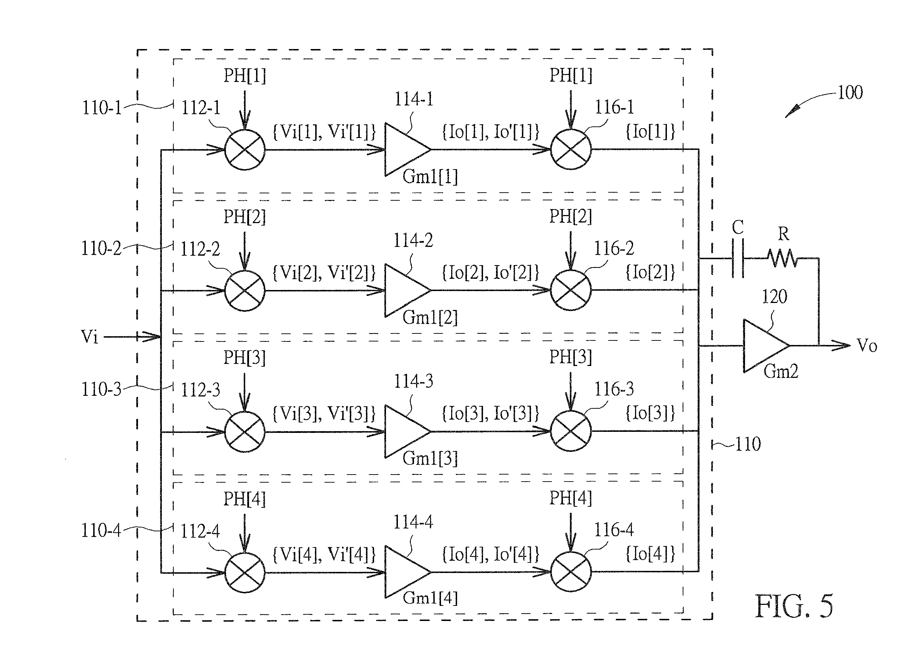

FIG. 5 illustrates some amplifying paths of one of the gain stages 110 and 120 shown in FIG. 1 according to another embodiment of the present invention, such as the N amplifying paths 110-1, 110-2, ..., and 110-N of the gain stage 110 mentioned above in a situation where the number N of the amplifying paths 110-1, 110-2, ..., and 110-N of the gain stage 110 is equal to four. This embodiment is a variation of the embodiment shown in FIG. 2. For brevity, similar descriptions for this embodiment are not repeated in detail here.

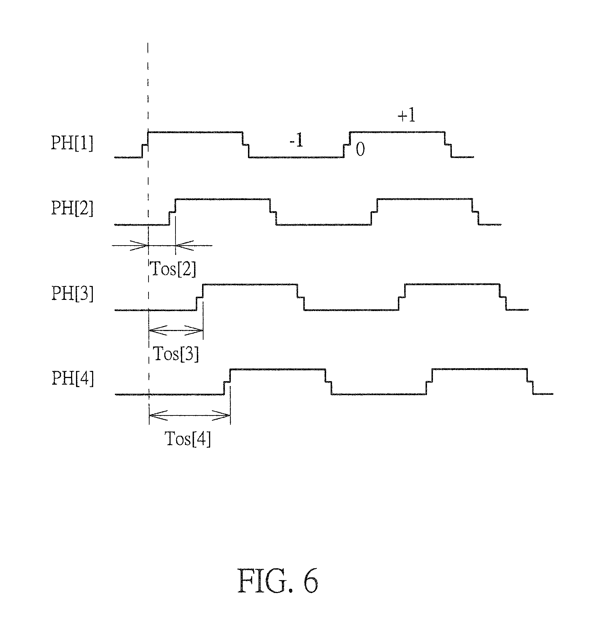

FIG. 6 illustrates the waveforms of some switching control signals PH[1], PH[2], PH[3], and PH[4] involved with the method 200 shown in FIG. 3 according to another embodiment of the present invention, where the number N of the amplifying paths 110-1, 110-2, ..., and 110-N of the gain stage 110 can be equal to four in this embodiment. This embodiment is a variation of the embodiment shown in FIG. 4. For brevity, similar descriptions for this embodiment are not repeated in detail here.

FIG. 7 illustrates the waveforms of some switching control signals PH[1], PH[2], ..., and PH[N] involved with the method 200 shown in FIG. 3 according to an embodiment of the present invention. Please note that most of the notations used in this embodiment can be the same as that used in the embodiments disclosed above, except that the notation Tdz can be utilized for representing a transition time interval, and more particularly, a time interval of the transition between opposite states (e.g. two opposite states such as the non-inverting state "+1" and the inverting state "-1" with the non-inverting state "+1" coming first, or two opposite states such as the inverting state "-1" and the non-inverting state "+1" with the inverting state "-1" coming first) in a period of any of the switching control signals PH[1], PH[2], ..., and PH[N] of this embodiment.

According to this embodiment, each of the partial waveforms illustrated with bold lines in any of the switching control signals PH[1], PH[2], ..., and PH[N] of this embodiment may represent a transition time interval such as that mentioned above. As shown in the bottommost of FIG. 7, the partial waveforms may vary based on different control schemes of the method 200 shown in FIG. 3. For example, according one of these control schemes regarding the transition control, such as that shown in the bottom left of FIG. 7, the transition between the opposite states mentioned above can be abrupt, and the slop of the corresponding partial waveform may be very great. In another example, according another one of these control schemes regarding the transition control, such as that next to the control scheme shown in the bottom left of FIG. 7, the transition between the opposite states mentioned above can be slower than that of the previous example, and the slop of the corresponding partial waveform may be a smaller value. In another example, according yet another one of these control schemes regarding the transition control, such as that shown in the bottom right of FIG. 7, the transition between the opposite states mentioned above can be implemented with the zero state "0" mentioned above, and in this situation, the notation Tdz may represent the length of the aforementioned dead zone corresponding to the zero state "0" mentioned above. For brevity, similar descriptions for this embodiment are not repeated in detail here.

All combinations and sub-combinations of above-described features also belong to the invention.

## Claims

1. A method for performing signal amplifying with aid of switching control, **characterized in that** the method comprises the steps of:
modulating an input signal of a gain stage (110) based on one of several modulation schemes to generate at least one first amplified result of a first amplifying path (110-1) of the gain stage (110);
modulating the input signal of the gain stage (110) based on one of the several modulation schemes to generate at least one second amplified result of a second amplifying path (110-2) of the gain stage (110); and
generating an amplified signal of the gain stage (110) based on at least the first amplified result and the second amplified result;
wherein at least one switching time point of the first amplifying path (110-1) for switching between the several modulation schemes and one switching time point of the second amplifying path (110-2) for switching between the several modulation schemes are non-overlapped.

2. The method of claim 1, **characterized in that** the several modulation schemes comprises providing a non-inverted version of the input signal, providing a zero-version of the input signal, and providing an inverted version of the input signal.

3. The method of claim 2, **characterized in that** a time period of providing the zero-version of the input signal for the first amplifying path (110-1) and a time period of providing the zero-version of the input signal for the first amplifying path (110-2) are non-overlapped.

4. The method of claim 2, **characterized in that** a time period of providing the non-inverted version of the input signal and a time period of providing an inverted version of the input signal are substantially even.

5. The method of claim 1, **characterized in that** the step of modulating the input signal of the gain stage (110) based on one of several modulation schemes to generate at least one first amplified result of the first amplifying path (110-1) of the gain stage (110) further comprises demodulating an amplified result based on one of several demodulation schemes to generate the at least one first amplified result of the first amplifying path (110-1) of the gain stage (110); the step of modulating the input signal of the gain stage (110) based on one of several modulation schemes to generate at least one second amplified result of the first amplifying path (110-2) of the gain stage (110) further comprises demodulating an amplified result based on one of the several demodulation schemes to generate the at least one second amplified result of the first amplifying path (110-2) of the gain stage (110); and at least one switching time point of the first amplifying path (110-1) for switching between the several demodulation schemes and one switching time point of the first amplifying path (110-2) for switching between the several demodulation schemes are non-overlapped.

6. The method of claim 1, **characterized in that** the first amplifying path (110-1) comprises a first operational transconductance amplifier and the first amplifying path (110-2) comprises a second operational transconductance amplifier.

7. The method of claim 1, **characterized in that** the step of modulating the input signal of the gain stage (110) for the first amplifying path (110-1) of the gain stage (110) is controlled by a first switching control signal, the step of modulating the input signal of the gain stage (110) for the first amplifying path (110-2) of the gain stage (110) is controlled by a second switching control signal, and the second switching control signal is a delayed version of the first switching control signal.

8. The method of claim 7, **characterized in that** both of the first and second switching control signals comprise a non-inverting state, a zero state, and an inverting state.

9. A method for performing signal amplifying with aid of switching control, **characterized in that** the method comprises the steps of:
selectively enabling or disabling N amplifying paths ({110-n}, {110-1, 110-2, ..., 110-N}) of a gain stage (110) based on N switching control signals, respectively, where N is a positive integer equal to or larger than two; and
generating an amplified signal of the gain stage (110) based on N amplified results generated by the N amplifying paths ({110-n}, {110-1, 110-2, ..., 110-N});
wherein the N amplifying paths ({110-n}, {110-1, 110-2, ..., 110-N}) are not disabled at the same time.

10. The method of claim 9, **characterized in that** the step of selectively enabling or disabling N amplifying paths ({110-n}, {110-1, 110-2, ..., 110-N}) comprises selectively inputting or not inputting an input signal to the N amplifying paths ({110-n}, {110-1, 110-2, ..., 110-N}).

11. The method of claim 9, **characterized in that** the step of selectively enabling or disabling N amplifying paths ({110-n}, {110-1, 110-2, ..., 110-N}) comprises selectively outputting or not outputting amplified results of the N amplifying paths ({110-n}, {110-1, 110-2, ..., 110-N}).

12. An apparatus (100) for performing signal amplifying with aid of switching control according to claims 1-11.
